# DEMANDE DE BREVET EUROPEEN

(11) **EP 4 790 898 A1**
(43) Date de publication de la demande: **12.08.2026**
(21) Numéro de dépôt: 26154892.9
(22) Date de dépôt: 29.01.2026
(51) Int. Cl.: H03K 4/502, H02M 3/156, H03K 7/08

(54) **CIRCUIT INTÉGRÉ CONFIGURÉ POUR GÉNÉRER UN SIGNAL À MODULATION DE LARGEUR D'IMPULSION**

(30) Priorité: 05.02.2025 FR 2501185
(71) Demandeur: STMicroelectronics International N.V., 1228 Plan-les-Ouates, Geneva (CH)
(72) Inventeur: Onde, Vincent, 13710 Fuveau (FR)
(74) Mandataire: Casalonga

(57) **Abrégé**

Selon un aspect, il est proposé un circuit intégré comprenant un circuit (GENC) de génération en mode courant d'un signal à modulation de largeur d'impulsions, ce circuit (GENC) de génération comportant un circuit (DAC) de conversion numérique-analogique utilisé pour réaliser une compensation de pente d'un signal (CURS_V) généré par un capteur de courant et ayant une tension comprise entre une tension de référence et un seuil de tension, ledit circuit (DAC) de conversion numérique-analogique comprenant :
- un module numérique configuré pour générer un signal numérique, et
- un module de conversion configuré pour convertir ledit signal numérique en un signal analogique de compensation de pente, dans lequel le signal numérique est généré à partir d'une rampe numérique écrêtée de sorte que le signal analogique de compensation de pente présente une tension comprise entre la tension de référence et ledit seuil de tension.

## Description

Des modes de réalisation et de mise en œuvre concernent la génération de signaux à modulation de largeur d'impulsion, notamment pour une alimentation à découpage.

Une alimentation à découpage est un dispositif électrique configuré pour fournir une alimentation électrique à une charge en utilisant un régulateur à découpage afin de convertir une puissance électrique.

En particulier, le signal d'alimentation est obtenu en modulant une tension continue à partir d'un signal haute fréquence à l'aide d'un commutateur, par exemple un transistor à effet de champ à grille isolée (désigné également par l'abréviation « MOSFET » de l'anglais « Metal-Oxide-Semiconductor Field-Effect Transistor ») ou bien un transistor bipolaire à grille isolée (désigné également par l'abréviation « IGBT » de l'anglais « Insulated-Gate Bipolar Transistor »).

En particulier, un signal à modulation de largeur d'impulsion (également désigné par l'expression « signal « PWM » », « PWM » étant une abréviation de l'anglais « Pulse Width Modulation ») est utilisé pour commander le commutateur utilisé pour transmettre l'énergie fournie par la tension continue à la charge. Ce signal « PWM » permet ainsi de contrôler la durée pendant laquelle l'énergie est fournie à la charge.

Un signal « PWM » est caractérisé par une fréquence et par un rapport cyclique. La fréquence défini le nombre de cycles par seconde du signal « PWM », et ainsi une période d'un cycle du signal « PWM ». Le rapport cyclique permet de définir une durée pendant laquelle l'état du signal « PWM » est à l'état haut pendant un cycle du signal « PWM ».

La génération d'un signal « PWM » peut être contrôlée en mode tension ou bien en mode courant.

Le mode courant peut entraîner des instabilités connues sous le nom de oscillations sous-harmoniques lorsque le rapport cyclique est supérieur à 50%.

Pour prévenir ces instabilités, on applique une compensation de pente en utilisant un signal supplémentaire (rampe artificielle). La compensation de pente permet d'éliminer les oscillations sous-harmoniques, et ainsi de stabiliser la génération du signal « PWM ».

Il est notamment possible de générer une rampe numérique pour réaliser une compensation de pente. En particulier, la rampe numérique est convertie en un signal analogique proportionnel à la rampe numérique.

Plus particulièrement, un compteur peut être utilisé pour générer cette rampe numérique en incrémentant ou en décrémentant une valeur du compteur. Le compteur est configuré pour effectuer plusieurs cycles de comptage de sorte que le signal numérique obtenu en sortie du compteur présente une forme en dents de scie.

Le compteur est configuré pour incrémenter ou décrémenter sa valeur entre zéro et une valeur maximale du compteur. Ainsi, cette valeur numérique permet de générer un signal analogique ayant une tension comprise entre 0 Volt et une tension de référence interne Vref, par exemple une tension d'alimentation Vdd du circuit intégré.

Le signal analogique obtenu après conversion de la rampe numérique est ensuite comparé à un signal proportionnel à un courant transmis à la charge. En particulier, des capteurs de courant peuvent être utilisés pour mesurer le courant transmis à la charge et pour générer un signal proportionnel à ce courant.

Toutefois, certains capteurs de courant sont configurés pour effectuer des mesures de courant bidirectionnelles, par exemple dans le cadre de chargeur de batterie bidirectionnel. Par exemple, un tel capteur de courant peut être un capteur magnétorésistif anisotrope ou bien un capteur à effet Hall.

Ces capteurs sont configurés pour générer des tensions permettant d'indiquer des courants mesurés positifs ou négatifs. Ces tensions sont centrées sur une tension centrale non nulle, par exemple égale à Vref/2 lorsque la tension minimale pouvant être générée est égale à 0 Volt, où Vref est une tension de référence interne, par exemple la tension d'alimentation Vdd du circuit intégré ou une tension d'alimentation du capteur de courant. Les tensions inférieures à Vref/2 correspondent à des courants provenant de la charge et les tensions supérieures à Vref/2 correspondent à des courants transmis à la charge.

Or, comme indiqué précédemment, le signal analogique obtenu après conversion de la rampe numérique varie entre 0 Volt et Vref. Ainsi, la tension de ce signal analogique peut être incohérente par rapport au signal généré par le capteur de courant lorsqu'elle est comprise entre 0 Volt et Vref/2 alors que la tension générée par le capteur de courant est comprise entre Vref/2 et Vref. Il n'est alors pas possible de générer un signal « PWM » correctement.

La rampe numérique générée pour la compensation de pente n'est donc pas compatible avec de tels capteurs de courant bidirectionnel.

En effet, une telle rampe numérique est seulement adaptée pour les capteurs de courant unidirectionnels référencés à la masse (par exemple des capteurs résistifs).

Il existe donc un besoin de proposer une solution permettant de générer correctement un signal « PWM » lorsqu'un capteur de courant bidirectionnel est utilisé pour mesurer un courant transmis à la charge.

Selon un aspect, il est proposé un circuit intégré comprenant un circuit de génération en mode courant d'un signal à modulation de largeur d'impulsions, ce circuit de génération comportant un circuit de conversion numérique-analogique utilisé pour réaliser une compensation de pente d'un signal généré par un capteur de courant et ayant une tension comprise entre une tension de référence et un seuil de tension, ledit circuit de conversion numérique-analogique comprenant :
- un module numérique configuré pour générer un signal numérique, et
- un module de conversion configuré pour convertir ledit signal numérique en un signal analogique de compensation de pente,
dans lequel le signal numérique est généré à partir d'une rampe numérique écrêtée de sorte que le signal analogique de compensation de pente présente une tension comprise entre la tension de référence et ledit seuil de tension.

Un tel module numérique permet ainsi d'éviter d'avoir une incohérence entre la tension générée par le convertisseur numérique-analogique et la tension d'un signal généré par le capteur de courant, en restant dans un même intervalle de tensions.

Un tel module numérique permet donc d'utiliser un capteur de courant bidirectionnel en générant un signal numérique respectant le sens du courant transmis à une charge.

Ainsi, dans un mode de réalisation avantageux, ledit capteur de courant est un capteur de courant bidirectionnel configuré pour fonctionner sur une plage de tensions limitée par une tension de référence maximale et une tension de référence minimale et centrée sur une tension centrale non nulle, par exemple égale à la tension de référence maximale divisée par deux lorsque la tension de référence minimale est égale à 0 Volt, le capteur de courant étant configuré pour générer un signal ayant une tension comprise entre l'une de ces tensions de référence et ladite tension centrale non nulle selon un sens d'un courant mesuré.

Avantageusement, le seuil de tension est compris entre la tension de référence maximale et la tension centrale non nulle.

De préférence, le module numérique comprend :
- un compteur configuré pour générer une rampe numérique,
- un module d'écrêtage configuré pour générer la rampe numérique écrêtée en comparant une valeur du compteur à une première valeur seuil associée audit seuil de tension.

Dans un mode de réalisation avantageux, le module d'écrêtage est configuré pour générer la rampe numérique écrêtée en comparant également la valeur du compteur à une deuxième valeur seuil associée à ladite tension de référence.

Avantageusement, le compteur est configuré pour incrémenter ou décrémenter sa valeur afin de générer la rampe numérique, ladite valeur du compteur étant incrémentée ou décrémentée à une fréquence définie par un signal d'horloge correspondant à un sous-multiple d'une horloge utilisée pour la génération du signal à modulation de largeur d'impulsion, le compteur définissant un pas d'incrémentation ou de décrémentation correspondant à une pente de la rampe numérique.

De préférence, le compteur est configuré pour décrémenter sa valeur à partir d'une valeur maximale de manière à obtenir une rampe numérique ayant une pente négative.

Dans un mode de réalisation avantageux, la première valeur seuil est une valeur minimale du signal numérique.

Avantageusement, la deuxième valeur seuil est une valeur maximale du signal numérique.

De préférence, la valeur maximale du compteur est supérieure à la valeur maximale du signal numérique. De la sorte, un tel compteur permet d'étendre virtuellement la compensation de pente au-delà de la valeur maximale du signal numérique.

Dans un mode de réalisation avantageux, le circuit intégré comprend en outre :
- un premier registre configuré pour stocker le pas de décrémentation du compteur,
- un deuxième registre configuré pour stocker la valeur maximale du compteur,
- un troisième registre configuré pour stocker la valeur du compteur.

Avantageusement, le circuit intégré comprend en outre un quatrième registre configuré pour stocker la valeur minimale du signal numérique.

De préférence, le circuit intégré comprend en outre un cinquième registre configuré pour stocker la valeur maximale du signal numérique

Dans un mode de réalisation avantageux, le module d'écrêtage est configuré pour :
- comparer la valeur du compteur à la première valeur seuil et à la deuxième valeur seuil, et
- générer en sortie une valeur du signal numérique égale à :
   - la valeur du compteur lorsque la valeur du compteur est comprise entre la première valeur seuil et la deuxième valeur seuil,
   - la première valeur seuil lorsque la valeur du compteur est inférieure ou égale à la première valeur seuil,
   - la deuxième valeur seuil lorsque la valeur du compteur est supérieure ou égale à la deuxième valeur seuil.

Avantageusement, le module d'écrêtage est configuré pour comparer la valeur du compteur et pour générer la valeur du signal numérique à chaque coup d'horloge du signal d'horloge correspondant à un sous-multiple de l'horloge utilisée pour la génération du signal à modulation de largeur d'impulsion.

De préférence, le circuit intégré comprend en outre un sixième registre configuré pour stocker la valeur du signal numérique générée par le module d'écrêtage.

Dans un mode de réalisation avantageux, le troisième registre est configuré pour stocker un nombre de bits supérieur à un nombre de bits pouvant être stocké dans le sixième registre.

Avantageusement, le deuxième registre est configuré pour stocker un nombre de bits supérieur à un nombre de bits pouvant être stocké dans le sixième registre. De la sorte, le deuxième registre permet de stocker une valeur plus grande que la dynamique du signal numérique afin de pouvoir étendre virtuellement la compensation de pente au-delà de la valeur maximale du signal numérique.

D'autres avantages et caractéristiques de l'invention apparaîtront à l'examen de la description détaillée de modes de réalisation, nullement limitatifs, et des dessins annexés sur lesquels :
[Fig 1] ;
[Fig 2] ;
[Fig 3] ;
[Fig 4] ; et
[Fig 5] illustrent des modes de réalisation et de mise en œuvre de l'invention.

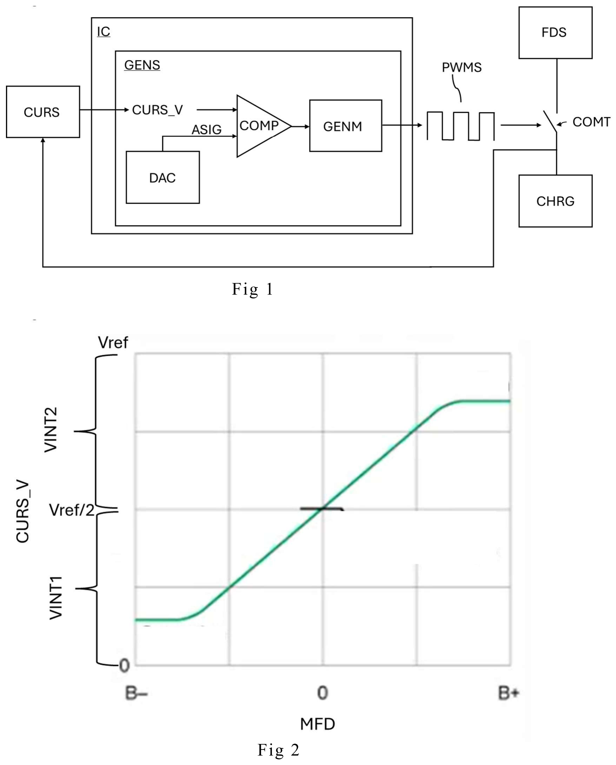

La figure 1 illustre un circuit intégré IC comportant un circuit GENS de génération d'un signal à modulation de largeur d'impulsions, désigné également par l'expression « signal PWM », abréviation de l'anglais « Pulse Width Modulation »).

Le circuit GENS de génération de signal « PWM » est configuré pour générer un signal « PWM », référencé PWMS, utilisé pour commander un commutateur COMT, par exemple un transistor à effet de champ à grille isolée (désigné également par l'abréviation « MOSFET » de l'anglais « Metal-Oxide-Semiconductor Field-Effect Transistor »).

La commande du commutateur COMT peut permettre une alimentation à découpage d'une charge CHRG à partir d'une source de tension continue FDS. La charge CHRG peut par exemple être un système électronique (par exemple une carte mère d'un serveur) ou bien une batterie.

Le signal « PWM » présente un train d'impulsions de largeur variable, généralement à une fréquence fixe. Un rapport cyclique des impulsions du signal « PWM » permet de définir la largeur des impulsions par rapport à une période du signal « PWM ».

Ce rapport cyclique permet ainsi de définir une durée d'un transfert d'énergie à partir d'une source d'alimentation continue vers la charge CHRG. Le rapport cyclique est défini en fonction des besoins de la charge CHRG afin de maintenir la tension d'alimentation de cette charge CHRG.

Ces besoins sont, par exemple, déduits d'une mesure de courant dans cette charge CHRG. La génération du signal « PWM » est alors effectuée dans un mode courant.

En particulier, un capteur de courant CURS peut être utilisé pour mesurer le courant dans la charge. Le capteur de courant CURS est notamment un capteur de courant CURS capable d'effectuer des mesures bidirectionnelles du courant dans la charge. Par exemple, le capteur de courant CURS est un capteur magnétorésistif anisotrope ou bien un capteur à effet Hall.

Le capteur de courant CURS est configuré pour générer une tension CURS_V dépendant du courant mesuré. La tension présente une valeur signée centrée sur une tension centrale, notamment égale à Vref/2 lorsque la tension minimale pouvant être générée par le capteur de courant est égale à 0 Volt, où Vref est une tension de référence interne, par exemple la tension d'alimentation Vdd du circuit intégré ou une tension d'alimentation du capteur de courant CURS.

Par exemple, la figure 2 illustre un graphique représentatif du fonctionnement d'un capteur de courant magnétorésistif. La tension CURS_V générée par le capteur de courant dépend d'une densité de flux magnétique MFD proportionnel au courant surveillé. La tension générée par le capteur de courant peut être comprise dans deux intervalles de tension VINT1 et VINT2. Un premier intervalle de tension VINT1 est défini entre 0 Volt et la tension centrale, par exemple égale à la tension de référence divisée par deux Vref/2. Un deuxième intervalle de tension VINT2 est défini entre la tension centrale, par exemple égale à Vref/2, et la tension de référence Vref. La tension générée par le capteur de courant dépend du signe du courant surveillé. Ainsi, par exemple, lorsqu'un courant est fourni à la charge CHRG, la tension générée par le capteur de courant est comprise dans le deuxième intervalle VINT2.

De retour à la figure 1, le circuit GENS de génération de signal « PWM » est configuré pour recevoir la tension CURS_V générée par le capteur de courant.

Le circuit GENS de génération de signal « PWM » comporte un comparateur COMP. Ce comparateur COMP présente une première entrée configurée pour recevoir une tension CURS_V générée par le capteur de courant, et une deuxième entrée configurée pour recevoir un signal analogique ASIG définissant une tension seuil correspondant à une consigne de tension souhaitée. La tension souhaitée est définie en fonction d'un courant moyen souhaité pour alimenter la charge CHRG.

Le signal analogique ASIG est généré par un circuit convertisseur numérique-analogique DAC du circuit GENS de génération de signal « PWM ».

Le circuit GENS de génération de signal « PWM » comprend en outre un module GENM de génération de signal « PWM ». Ce module GENM de génération de signal « PWM » est configuré pour générer le signal « PWM » à partir de la sortie du comparateur COMP.

En particulier, le module GENM de génération de signal « PWM » est configuré pour générer des impulsions à la fréquence d'une horloge. La sortie du comparateur COMP permet de déclencher une remise à zéro d'une rampe de courant générée par le module GENM de génération de signal « PWM », et donc la fin d'une impulsion à chaque cycle.

Afin d'éviter des instabilités connues sous le nom de oscillations sous-harmoniques lorsque le rapport cyclique du signal « PWM » est supérieur à 50%, le circuit convertisseur numérique-analogique DAC est configuré pour générer un signal analogique ASIG définissant une tension seuil pouvant varier dans le temps afin de réaliser une compensation de pente en regard de la rampe de courant du signal généré par le capteur de courant.

En particulier, le niveau de la tension de seuil peut suivre une rampe de tension permettant de stabiliser le fonctionnement du circuit de génération de signal « PWM ». Cette pente permet d'éliminer les oscillations sous-harmoniques lorsque le rapport cyclique du signal « PWM » est supérieur à 50%.

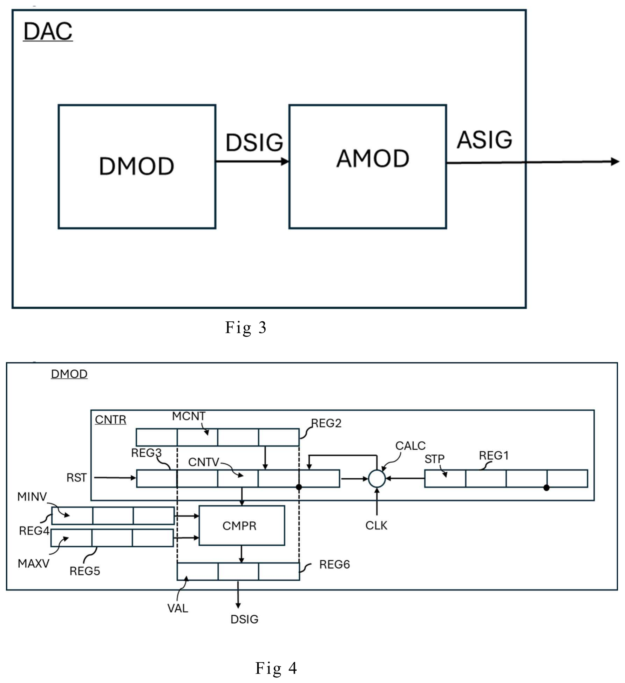

La figure 3 illustre un mode de réalisation d'un convertisseur numérique-analogique DAC utilisé pour réaliser la compensation de pente dans le circuit GENS de génération d'un signal « PWM ». Le convertisseur numérique-analogique DAC comporte un module numérique DMOD et un module de conversion AMOD. Le module numérique DMOD est un circuit numérique programmable configuré pour générer un signal numérique DSIG dont la valeur varie au cours du temps. Ce signal numérique DSIG est utilisé pour réaliser la compensation de pente après avoir été converti en un signal analogique ASIG par le module de conversion AMOD.

En particulier, le module de conversion AMOD est configuré pour générer un signal analogique ASIG ayant une tension conditionnée par la valeur numérique VAL portée par le signal numérique DSIG. Plus particulièrement, le module de conversion AMOD comprend notamment une pluralité de sources de courant, ou une pluralité de sources de tension, commandées individuellement par les bits du signal numérique DSIG afin de générer le signal analogique ASIG en sortie du module de conversion AMOD.

La figure 4 illustre un mode de réalisation d'un module numérique DMOD utilisé dans le convertisseur numérique-analogique DAC de la figure 3.

Comme vu précédemment, le module numérique DMOD est configuré pour générer une valeur numérique VAL variant dans le temps pour former le signal numérique DSIG.

En particulier, le module numérique DMOD comprend un compteur CNTR utilisé pour définir la valeur numérique VAL en sortie du module numérique DMOD.

Plus particulièrement, le compteur comprend un registre REG1 de stockage d'une valeur de pas STP du compteur. Le pas STP du compteur est défini selon la pente du courant d'alimentation.

Le compteur CNTR comprend également un registre REG2 de stockage d'une valeur maximale MCNT du compteur. Cette valeur maximale MCNT du compteur CNTR est définie de sorte que la valeur milieu du compteur CNTR puisse être associée à un courant moyen d'alimentation de la charge CHRG souhaité. Cette valeur maximale MCNT peut être modifiée au cours du temps.

Le compteur CNTR comporte un registre REG3 de stockage de la valeur numérique CNTV du compteur CNTR. La valeur numérique CNTV du compteur peut être initialisée à la valeur maximale MCNT lorsque le compteur est configuré pour décrémenter sa valeur CNTV stockée dans le registre REG3. Sinon, la valeur numérique CNTV peut être initialisée à zéro si le compteur est configuré pour incrémenter sa valeur CNTV stockée dans le registre REG3. La valeur numérique CNTV peut être réinitialisée à partir d'un signal RST de réinitialisation. Le signal RST est fourni par le module GENM de génération de signal « PWM ».

Le compteur CNTR comprend également un module CALC d'incrémentation ou de décrémentation de la valeur du compteur fonctionnant selon un signal d'horloge CLK. Ce signal d'horloge CLK correspond à un sous-multiple de l'horloge utilisée par le module GENM de génération de signal « PWM » pour générer le signal PWMS. La fréquence du signal d'horloge CLK peut être un ou deux ordres de grandeur plus faibles que la fréquence de l'horloge utilisée pour générer le signal PWMS. Par exemple, l'horloge utilisée pour générer le signal PWMS peut avoir une fréquence de 250MHz et le signal d'horloge CLK peut avoir une fréquence de 15MHz.

À chaque coup d'horloge du signal CLK, les contenus des registres REG1 et REG3 sont lus et la valeur numérique CNTV est incrémentée ou décrémentée de la valeur STP stockée dans le registre REG1.

En particulier, ce module CALC peut être configuré pour décrémenter la valeur stockée dans le registre REG3 à partir de la valeur maximale du compteur jusqu'à zéro avec le pas défini dans le registre REG1 selon le signal d'horloge CLK. Dans ce cas, l'incrémentation est effectuée par un circuit soustracteur.

En variante, le module CALC peut être configuré pour incrémenter la valeur stockée dans le registre REG3 à partir de zéro jusqu'à la valeur maximale du compteur avec le pas défini dans le registre REG1 selon le signal d'horloge CLK. Dans ce cas, l'incrémentation est effectuée par un circuit additionneur.

Le compteur CNTR est ainsi capable de générer une rampe numérique, notamment entre zéro et une valeur maximale MCNT. La pente de la rampe numérique est positive lorsque le compteur est configuré pour incrémenter sa valeur CNTV. La pente de la rampe numérique est négative lorsque le compteur est configuré pour décrémenter sa valeur CNTV.

Le module numérique DMOD comprend en outre un registre REG4 de stockage d'une valeur minimale MINV. Cette valeur minimale MINV correspond à une valeur numérique minimale pouvant être générée en sortie du module numérique DMOD.

Le module numérique comprend aussi un registre REG5 de stockage d'une valeur maximale MAXV. Cette valeur maximale MAXV correspond à une valeur numérique maximale pouvant être générée en sortie du module numérique DMOD. Cette valeur numérique maximale MAXV peut correspondre à la valeur permettant d'obtenir une valeur maximale du courant d'alimentation souhaitée.

Le module numérique DMOD comprend également un module d'écrêtage CMPR. Le module d'écrêtage CMPR est configuré pour comparer la valeur du compteur à la valeur minimale et à la valeur maximale et pour générer en sortie une valeur numérique en fonction d'un résultat de cette comparaison.

En particulier, lorsque la valeur CNTV du compteur CNTR est supérieure à la valeur minimale MINV et inférieure à la valeur maximale MAXV, la valeur numérique générée en sortie du module d'écrêtage CMPR correspond à la valeur CNTV du compteur CNTR.

Lorsque la valeur CNTV du compteur CNTR stockée dans le registre REG3 est inférieure ou égale à la valeur minimale MINV, la valeur numérique VAL générée en sortie du module d'écrêtage correspond à la valeur minimale MINV stockée dans le registre REG4.

Lorsque la valeur CNTV du compteur CNTR stockée dans le registre REG3 est supérieure ou égale à la valeur maximale MAXV, la valeur numérique VAL générée en sortie du module d'écrêtage correspond à la valeur maximale MAXV stockée dans le registre REG5.

Le module numérique DMOD comprend également un registre REG6 de sortie. Ce registre REG6 de sortie est configuré pour stocker la valeur numérique VAL en sortie du module d'écrêtage CMPR.

Ce registre REG6 de sortie est connecté au module de conversion AMOD décrit en relation avec la figure 3 afin de pouvoir transmettre cette valeur numérique VAL au module de conversion AMOD. Le module de conversion AMOD est alors configuré pour convertir cette valeur numérique en une tension associée à cette valeur numérique.

Avantageusement, la valeur minimale MINV du module numérique DMOD est choisie pour correspondre à un niveau de tension fixe supérieur à 0 V. Par exemple, la valeur minimale MINV du module numérique DMOD est choisi pour correspondre à un niveau de tension supérieur ou égal à Vref/2.

Une telle valeur minimale MINV permet par exemple de limiter la valeur numérique en sortie du module numérique DMOD à une valeur milieu du module numérique DMOD.

Une telle valeur minimale MINV permet donc d'éviter que la tension en sortie du module de conversion AMOD soit inférieure à la tension Vref/2.

Un tel module numérique DMOD permet de supporter un capteur de courant CURS adapté pour effectuer une mesure de courant bidirectionnel, notamment un capteur magnétorésistif anisotrope ou bien un capteur à effet Hall, non référencé à la masse. Un tel module numérique DMOD est également adapté pour supporter un capteur de courant unidirectionnel référencé à la masse. En effet, il est possible de définir une valeur maximale MAXV du signal numérique correspondant à la tension de référence Vref et une valeur minimale MINV du signal numérique correspondant à une tension nulle, ainsi qu'une valeur maximale MCNT du compteur CNTR correspondant à la valeur maximale MAXV du signal numérique.

Avantageusement, la valeur MAXV du compteur est adaptée par rapport à la valeur MINV définie.

En outre, la valeur maximale du compteur CNTR peut être supérieure à la valeur maximale MAXV en sortie du module numérique. Ainsi, la valeur maximale du compteur CNTR s'étend au-delà de la dynamique de la sortie du module numérique DMOD. Cela permet d'utiliser l'ensemble de la dynamique de la sortie du module numérique DMOD. Ainsi, un tel compteur permet d'étendre virtuellement la compensation de pente au-delà de la valeur maximale MAXV en sortie du module numérique.

De préférence, le registre REG3 de stockage est configuré pour stocker un nombre de bits supérieur à celui pouvant être stocké dans registre REG2 de stockage, et le registre REG2 de stockage est configuré pour stocker un nombre de bits supérieur à ceux pouvant être stockés dans les registres REG4, REG5 et REG6.

Par exemple, le registre REG1 de stockage est sur 16 bits, dont 4 bits pour une partie fractionnaire de la valeur stockée par ce registre. La partie fractionnaire permet d'améliorer la précision de la pente de la rampe générée par le module électronique. Le registre REG2 est sur 16 bits pour stocker un nombre entier.

Le registre REG3 est sur 20 bits, dont 4 bits pour une partie fractionnaire de la valeur stockée. La partie fractionnaire permet d'augmenter la finesse de la définition de la pente de la rampe numérique. Ainsi, au lieu d'avoir un incrément minimal de 1, il est possible d'avoir un incrément minimal jusqu'à 1/16. Dans ce cas, 16 cycles du signal d'horloge CLK sont nécessaires pour que la valeur décroisse d'une unité sur le signal DSIG fourni au module de conversion AMOD.

Les registres REG4 et REG5 sont sur 12 bits pour stocker des nombres entiers. Le registre REG6 est sur 12 bits pour stocker des nombres entiers.

Les bits du registre REG2 sont utilisés comme bits de la partie entière de la valeur du compteur stockée dans le registre REG3 lors de l'initialisation du registre REG3. Les 16 bits de poids fort de la partie entière de la valeur du compteur stockée du registre REG3 sont utilisés pour mettre à jour le registre de sortie REG6 lorsque cette valeur est comprise entre la valeur minimale MINV et la valeur maximale MAXV. Cela permet d'éviter d'adapter la sortie du module numérique DMOD à l'interface du module de conversion AMOD qui travaille ne valeur entière.

Par exemple, la valeur maximale du compteur peut être définie en hexadécimal jusqu'à la valeur 0xFFFF, la valeur maximale MAXV du module numérique peut être définie à 0x0FFF, et la valeur minimale MINV peut être définie à 0x07FF.

Sur la figure 4, les illustrations des registres REG1 à REG6 présentent des barres verticales délimitant des agrégats de 4 bits, soit un demi octet (en anglais « nibble »).

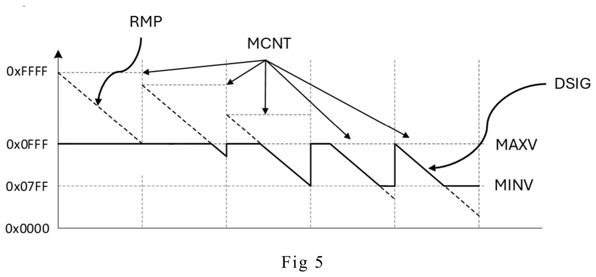

La figure 5 illustre un exemple de diagramme temporel montrant une évolution dans le temps de la valeur numérique en sortie du module numérique DMOD.

En particulier, le signal DSIG correspond à la valeur numérique en sortie du module numérique au cours du temps.

Le signal RMP correspond à la valeur CNTV du compteur au cours du temps. Le compteur CNTV est ici configuré pour décrémenter sa valeur CNTV.

Dans ce mode de mise en œuvre, la valeur maximale MAXV du module numérique peut être définie à 0x0FFF, et la valeur minimale MINV peut être définie à 0x07FF.

Ainsi, comme vu précédemment, la valeur numérique en sortie du module numérique est égale à la valeur maximale MAXV lorsque la valeur du compteur est supérieure ou égale à la valeur maximale MAXV, et est égale à la valeur minimale MINV lorsque la valeur du compteur est inférieure ou égale à la valeur minimale MINV. En outre, la valeur numérique en sortie du module numérique est égale à la valeur du compteur lorsque la valeur CNTV du compteur est comprise entre la valeur minimale MINV et la valeur maximale MAXV.

La valeur initiale MCNT pour chaque cycle du compteur CNTR est définie selon un courant moyen souhaité pour alimenter la charge CHRG.

## Revendications

1. Circuit intégré comprenant un circuit (GENC) de génération en mode courant d'un signal à modulation de largeur d'impulsions, ce circuit (GENC) de génération comportant un circuit (DAC) de conversion numérique-analogique utilisé pour réaliser une compensation de pente en regard d'un signal (CURS_V) généré par un capteur de courant (CURS) et ayant une tension comprise entre une tension de référence et un seuil de tension, ledit circuit (DAC) de conversion numérique-analogique comprenant :
- un module numérique (DMOD) configuré pour générer un signal numérique, et
- un module de conversion (AMOD) configuré pour convertir ledit signal numérique en un signal analogique de compensation de pente,
dans lequel le signal numérique est généré à partir d'une rampe numérique écrêtée de sorte que le signal analogique de compensation de pente présente une tension comprise entre la tension de référence et ledit seuil de tension.

2. Circuit intégré selon la revendication 1, dans lequel ledit capteur de courant (CURS) est un capteur de courant bidirectionnel configuré pour fonctionner sur une plage de tensions limitée par une tension de référence maximale et une tension de référence minimale et centrée sur une tension non nulle, le capteur de courant étant configuré pour générer un signal (CURS_V) ayant une tension comprise entre l'une de ces tensions de référence et ladite tension centrale non nulle selon un sens d'un courant mesuré.

3. Circuit intégré selon la revendication 2, dans lequel le seuil de tension est compris entre la tension de référence maximale (Vref) et la tension non nulle.

4. Circuit intégré selon l'une des revendications 1 à 3, dans lequel le module numérique (DMOD) comprend :
- un compteur (CNTR) configuré pour générer une rampe numérique,
- un module d'écrêtage (CMPR) configuré pour générer la rampe numérique écrêtée en comparant une valeur du compteur à une première valeur seuil associée audit seuil de tension.

5. Circuit intégré selon la revendication 4, dans lequel le module d'écrêtage (CMPR) est configuré pour générer la rampe numérique écrêtée en comparant également la valeur du compteur à une deuxième valeur seuil associée à ladite tension de référence.

6. Circuit intégré selon l'une des revendications 4 ou 5, dans lequel le compteur (CNTR) est configuré pour incrémenter ou décrémenter sa valeur afin de générer la rampe numérique, ladite valeur du compteur étant incrémentée ou décrémentée à une fréquence définie par un signal d'horloge (CLK) correspondant à un sous-multiple d'une horloge utilisée pour la génération du signal à modulation de largeur d'impulsion, le compteur (CNTR) définissant un pas d'incrémentation ou de décrémentation correspondant à une pente de la rampe numérique.

7. Circuit intégré selon la revendication 6, dans lequel le compteur (CNTR) est configuré pour décrémenter sa valeur à partir d'une valeur maximale de manière à obtenir une rampe numérique ayant une pente négative.

8. Circuit intégré selon la revendication 7, dans lequel la première valeur seuil est une valeur minimale du signal numérique.

9. Circuit intégré selon la revendication 8, dans lequel la deuxième valeur seuil est une valeur maximale du signal numérique.

10. Circuit intégré selon la revendication 9, dans lequel la valeur maximale du compteur est supérieure à la valeur maximale du signal numérique.

11. Circuit intégré selon l'une des revendications 7 à 10, comprenant en outre :
- un premier registre (REG1) configuré pour stocker le pas de décrémentation du compteur (CNTR),
- un deuxième registre (REG2) configuré pour stocker la valeur maximale du compteur,
- un troisième registre configuré (REG3) pour stocker la valeur du compteur (CNTR).

12. Circuit intégré selon l'une des revendications 8 à 10 et la revendication 11, comprenant en outre un quatrième registre (REG4) configuré pour stocker la valeur minimale du signal numérique.

13. Circuit intégré selon les revendications 9 et 12, comprenant en outre un cinquième registre (REG5) configuré pour stocker la valeur maximale du signal numérique.

14. Circuit intégré selon l'une des revendications 7 à 13, dans lequel le module d'écrêtage est configuré pour :
- comparer la valeur du compteur à la première valeur seuil et à la deuxième valeur seuil, et
- générer en sortie une valeur du signal numérique égale à :
• la valeur (CNTV) du compteur lorsque la valeur (CNTV) du compteur est comprise entre la première valeur seuil et la deuxième valeur seuil,
• la première valeur seuil lorsque la valeur (CNTV) du compteur est inférieure ou égale à la première valeur seuil,
• la deuxième valeur seuil lorsque la valeur (CNTV) du compteur est supérieure ou égale à la deuxième valeur seuil.

15. Circuit intégré selon la revendication 14, dans lequel le module d'écrêtage (CMPR) est configuré pour comparer la valeur du compteur et pour générer la valeur du signal numérique à chaque coup d'horloge du signal d'horloge (CLK) correspondant à un sous-multiple de l'horloge utilisée pour la génération du signal à modulation de largeur d'impulsion.

16. Circuit intégré selon l'une des revendications 14 ou 15 et la revendication 13, comprenant en outre un sixième registre configuré pour stocker la valeur du signal numérique générée par le module d'écrêtage.

17. Circuit intégré selon la revendication 16, dans lequel le troisième registre (REG3) est configuré pour stocker un nombre de bits supérieur à un nombre de bits pouvant être stocké dans le sixième registre (REG6).

18. Circuit intégré selon la revendication 16 ou 17, dans lequel le deuxième registre (REG2) est configuré pour stocker un nombre de bits supérieur à un nombre de bits pouvant être stocké dans le sixième registre (REG6).
